# EUROPEAN PATENT SPECIFICATION

(11) **EP 4 184 179 B1**
(45) Date of publication and mention of the grant of the patent: **01.07.2026**
(21) Application number: 22020563.7
(22) Date of filing: 16.11.2022
(51) Int. Cl.: G01R 27/02, G01R 27/18, G01R 31/52, H02H 5/12

(54) **APPARATUS FOR MEASURING LOOP IMPEDANCE AND CORRESPONDING METHOD**
VORRICHTUNG ZUR MESSUNG DER SCHLEIFENIMPEDANZ UND ENTSPRECHENDES VERFAHREN
APPAREIL PERMETTANT DE MESURE DE L'IMPÉDANCE DE BOUCLE ET PROCÉDÉ CORRESPONDANT

(30) Priority: 17.11.2021 IT 202100029099
(43) Date of publication of application: 24.05.2023
(73) Proprietor: Uniks S.r.l., 48018 Faenza (RA) (IT)
(72) Inventor: Scuro, Francesco, 48018 FAENZA (RA) (IT); Ronconi, Stefano, 48018 FAENZA (RA) (IT)
(74) Representative: Montebelli, Marco

(56) References cited:
- EP-A1- 3 835 798
- EP-A2- 1 764 619
- WO-A1-2015/018019
- WO-A1-2021/156608
- CN-A- 102 116 814
- US-A1- 2013 191 059

## Description

This invention relates to an apparatus for measuring loop impedance and to the related method.

It is universally known that the use of electricity involves potentially dangerous situations.

In fact, if due to faults in the apparatuses used the electric current were to circulate in the human body, the consequences could cause irreversible damage up to even cardiac arrest.

On the other hand, higher than predicted electric currents arising may cause fires which would endanger people and property.

For these reasons it is necessary to design safety devices which allow the "discharge to earth" of any electric currents caused by a fault or which immediately interrupt the current should this occur.

Loop impedance, defined as the total impedance of the conductors which carry electricity from the generator to the electrical equipment, is a fundamental quantity for sizing such devices. Thanks to this it is possible to know the maximum total current which can circulate and therefore to define which devices to install in order to interrupt the power supply in the event of a fault.

The mainly low voltage electricity distribution systems used are marked with the codes TT and TN.

In TT systems both the neutral point of the power system and the earth of the equipment are directly and separately connected to earth, whilst in TN systems the neutral point of the power system is directly connected to earth, but the earth of the equipment is connected to the earthed point of the power system.

The TT system is typically used for domestic user equipment, in which the low voltage power supply is produced directly by the power distributor; in contrast, the TN system is typical in the case of users with their own transformer cabin, as is the case, for example for large civil structures such as hospitals, hotels, supermarkets, or for industrial users.

Depending on the type of circuit affected by a fault current which may arise, reference is made to phase-phase, phase-neutral or phase-earth loop impedance: in the first two cases, the impedance value does not usually exceed 10 ohms, and therefore there are short-circuit currents in the tens of amperes. In contrast, to avoid electrocution, the fault current must be much lower, at around several tens of milliamperes: the protection circuit in TN systems comprises a copper wire, whilst in TT systems it comprises the earth, to which an impedance much higher than that of any conductor corresponds. Therefore, it follows that measurement of the phase-earth loop impedance is usually sufficient to give an indication of system safety.

In prior art systems, in order to be able to measure the loop impedance a current is made to flow through that loop by means of a specific circuit and simultaneously the corresponding voltage value is measured. Unfortunately this measurement is affected by many causes of uncertainty, and attempts to overcome these have not been entirely satisfactory: in fact it should be considered that the network voltage is not constant and the network frequency often has irregularities; moreover, there may be various types of interference on the network conductors generated by loads placed downstream and upstream of the measurement, there may be interference on the earth conductor, and this "noise" may in any case not be stable and may be extremely random.

Various methods are currently used to reduce these disadvantages: for example, an intermittent passive load is applied which allows a very high current to be made to flow in the phase-phase or phase-neutral conductors at the network frequency; however, this method, which measures the variation in the network voltage from a load condition to a no load condition, gives reliable results for currents of various amperes, but cannot be used for the phase-earth loop impedance measurement since it would trip the system cutout devices.

Another method involves pulse generation of a high phase-phase, phase-neutral and phase-earth current: loading the network conductors with a pulse of current for a short time avoids tripping the cutout devices and also allows measurement of the phase-earth impedance, but the interference on the earth conductor cannot be eliminated.

Moreover, the use of high currents involves the use of a larger number of components which increase the weight and dimensions of the measuring instruments, from several hundred grams and around twenty centimetres up to several kilograms and the dimensions of a suitcase.

A further method involves generation of a neutral-earth current signal at frequencies which are different from the network frequency, but which are predetermined: in this case, a current of around 15 milliamperes generated by the measuring instrument is used to avoid tripping the cutout devices, with a frequency different from the network voltage; however, between neutral and earth the network voltage is not present, only various types of interference, therefore measurement of the neutral-earth loop impedance is only reliable in TT systems thanks to the high value of the earth resistance.

Relevant background art is represented by the Chinese patent application No. CN 102116814 A and by the US patent application No. US 2013/191059 A1.

Other relevant background art is represented by the European patent application No. EP 3 835 798 A1, concerning a method and an apparatus for measuring the impedance of the fault loop, and the European patent application No. EP 1 764 619 A2, concerning testing loop impedance in a circuit having a residual current operated circuit breaker (RCCB).

The aim of this invention is therefore to eliminate the above-mentioned disadvantages.

The invention, as characterised by the claims, achieves the aim thanks to an arbitrary and modifiable definition of the frequency band in which the signal is generated and to a good quality selection of the fundamental frequency.

The main advantage obtained by means of this invention is basically the fact that the choice of the frequency allows the effects of the interference to be minimised, and that allows the use of generating currents which are very low relative to the precision required, obtaining measurement of the phase-earth loop impedance without tripping the cutout devices and using instruments with dimensions and weight which are much less than those of the prior art instruments. Even acquisition of the voltage signal allows selection of the frequency identified as the most free of interference, also allowing elimination of the network signal. Furthermore, selection of the frequency occurs by adapting to the interference situation at the moment of the measurement.

Moreover, the measuring current generated is made to flow from one phase towards each of the other conductors, creating a single circuit for all types of loop impedance measurement:
phase-phase, phase-neutral, phase-earth.

Current generation and the measurement are carried out simultaneously on two nodes of the loop without deriving and involving multiple measuring methods.

Finally, the low current generating circuit can be implemented with circuits which are simple and easily scalable in terms of power, suitable for being fitted on a wide range of measuring instruments, from the most compact to the most complete and powerful.

Further advantages and features of the invention will be more apparent in the detailed description which follows, with reference to the accompanying drawings, which show an example, non-limiting embodiment, in which:
- Figure 1 is a schematic view of an embodiment of the invention, falling under the claimed invention;
- Figure 2 is a flow chart of a measuring method falling under the claimed invention;
- Figure 3 is a schematic diagram of the measuring method; and
- Figure 4 is a general diagram of the intended use of the invention.

The invention relates to an apparatus for measuring loop impedance and to the related measuring method.

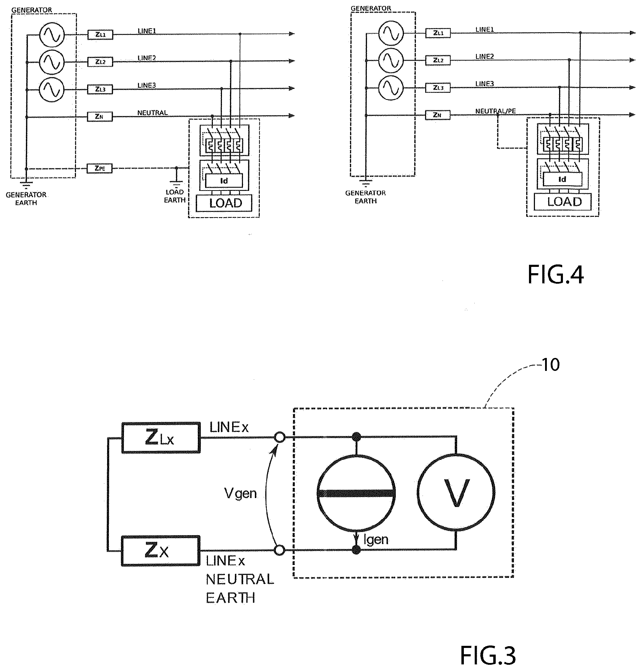

Both the apparatus 10 and the method are usable in the most widespread power distribution systems, such as the TT and TN systems, schematically shown in Figure 4.

The schematic diagram of the loop impedance measurement is shown in Figure 3, in which the impedances Zlx and Zx relate to the branches of the generic circuit. According to this diagram, the loop impedance is calculated as the ratio of Vgen to Igen which are measured simultaneously at the generator terminals.

In a preferred embodiment of the invention, falling under the claimed invention, the apparatus 10 for measuring loop impedance comprises a differential amplifier 1 configured to condition a Vgen input signal, a controlled current generator 5 capable of making an Igen current signal flow between measuring terminals A, B, and a microcontroller 6 set up for acquisition of the signals, for processing the signals and for controlling the current generator 5. The microcontroller 6 comprises a frequency selector 2, configured to analyse the Vgen signal for identifying frequencies which are free of network interference, a digital filter 3, configured to extract the component of Vgen derived from application of the Igen current, and processing means 4 configured to supply the impedance measurement. The frequency selector 2 comprises an analogue-to-digital converter 21, configured to collect samples of the value of Vgen, saving means 22 for saving the samples collected, and analysing means 23 for analysing those samples.

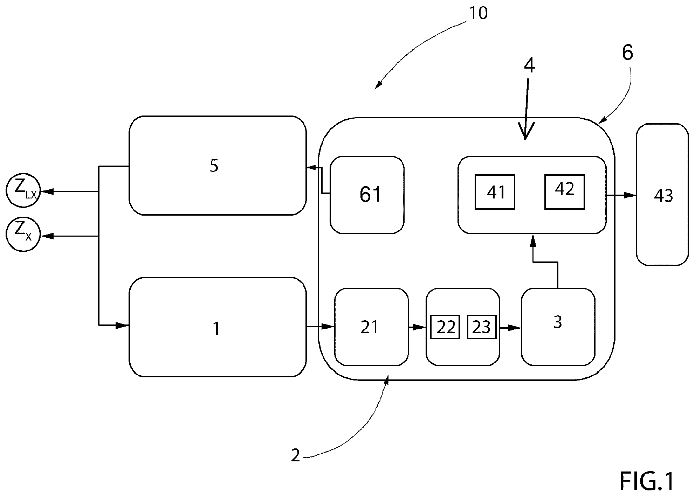

As shown in Figure 1, the voltage measurement at the current generator 5 terminals is taken using the differential amplifier 1 which conditions the input signal, having a maximum peak-to-peak voltage of 650 volts for single-phase devices or 1100 volts for three-phase devices, in such a way as to bring it to a 3V peak-to-peak and to make it suitable for acquisition by the analogue-to-digital converter 21 present in the microcontroller 6 downstream of the differential amplifier 1.

It acquires samples at the rate of two million per second and uses the oversampling technique to increase the measuring precision to the detriment of the rate which may thereby be reduced to 8500 samples per second. The samples are saved in the saving means 22, preferably consisting of buffers, then they are analysed by the analysing means 23.

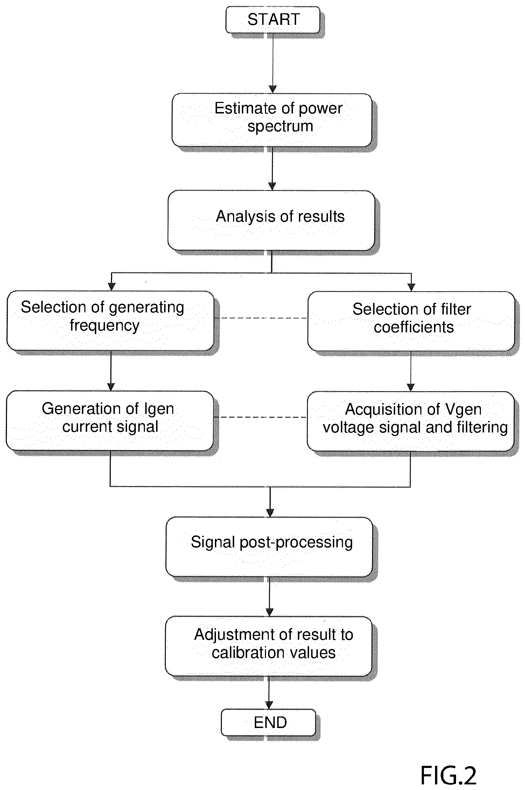

Figure 2 shows the flow chart of the measuring method falling under the claimed invention: a first analysis of the Vgen signal is carried out with Igen equal to zero to identify the frequency which is most free of interference, Fgen, within a range between 0 and 200 Hertz, calculating the estimate of the power spectrum of Vgen and selecting the component with the magnitude which is on average the lowest. Welch's method is used, which requires the average of the output samples from a Fourier transform calculation block, whilst the input samples are windowed using the Hanning function.

When the step of studying Vgen signal interference has been completed and Fgen has been identified, we move on to the actual measuring step, during which the Igen signal is generated in the loop impedances using the terminals A, B of the current generator 5, and simultaneously the band-pass type digital filter 3 is activated. The digital filter 3 and the current generator 5 are consistently set on the Fgen frequency previously identified: the passband frequency of the band-pass type digital filter 3 is set equal to Fgen, whilst the current generator 5, controlled by the microcontroller 6 by means of a digital-to-analogue converter 61, is capable of causing the Igen current to flow in the measuring loop at the Fgen frequency in a precise way and with a known magnitude of around 15 milliamperes. Igen current flowing at the Fgen frequency on the loop impedances causes a drop in the potential of the Vgen signal, or component of Vgen at the Fgen frequency. The samples of Vgen at the analogue-to-digital converter 21 output and brought to the digital filter 3 input, are processed and selected by it. The output consists only of the samples of the component of Vgen having the Fgen frequency, since the digital filter 3 is capable of lowering the other unwanted frequencies -120dB. The output signal from the digital filter 3 is then averaged and scaled based on the calibration parameters of the apparatus 10. Therefore, the loop impedance will be the ratio of the magnitude of the component of Vgen at the digital filter 3 output to 15 milliamperes. In this case the current generator 5 is a MOSFET transistor capable of modifying its output resistance in an arbitrary way in the (230V) network voltages range. Other circuits may be implemented using MOSFETs which operate at voltages greater than 400V or high frequency switching circuits.

The processing means 4 comprise calculating means 41 for calculating the effective value of the filtered Vgen signal, comparing means 42 for comparing with a predetermined setting table and displaying means 43 for displaying the measurement obtained.

The method for measuring loop impedance, which can be carried out by the apparatus 10 described above therefore comprises at least the following steps: measurement of the Vgen input signal at the terminals A, B of the current generator 5 using the differential amplifier 1 and conditioning of the signal; transmission of the conditioned signal, sampling and saving of the data collected, and selection of a frequency in a range between 0 and 200 Hertz which is free of interference identified by calculating an estimate of the power spectrum of Vgen and selecting the component with the magnitude which is on average the lowest using the frequency selector 2; generation by the current generator 5 of the Igen current at the frequency identified; filtering of the Vgen signal by the digital filter 3, in such a way as to extract the component of Vgen at the frequency identified; and processing of the filtered Vgen signal and calculation of the loop impedance as the ratio of Vgen to Igen which are measured simultaneously at the terminals A, B of the current generator 5 by the processing means 4.

## Claims

1. Apparatus (10) for measuring loop impedance, comprising a differential amplifier (1) configured to condition a Vgen input signal, and a current generator (5), controlled by a microcontroller (6), configured to make an Igen current signal flow between two measuring terminals A, B, wherein the microcontroller (6) comprises a frequency selector (2), configured to identify frequencies which are free of interference in a range between 0 and 200 Hertz in such a way as to generate an Igen current at the frequency identified, a digital filter (3), configured to extract only the component of Vgen at the frequency identified, and processing means (4) for processing the filtered Vgen signal, which are configured to supply the impedance measurement, **characterised in that** the frequency selector (2) is configured to identify frequencies which are free of interference in a range between 0 and 200 Hertz by calculating an estimate of the power spectrum of Vgen and selecting the component with the magnitude which is on average the lowest.

2. Apparatus (10) according to claim 1, wherein the frequency selector (2) comprises an analogue-to-digital converter (21), configured to collect samples of the value of Vgen, saving means (22) for saving the samples collected, and analysing means (23) configured to identify the frequencies most free of interference.

3. Apparatus (10) according to claim 1 or 2, wherein the processing means (4) comprise calculating means (41) for calculating the effective value of the filtered Vgen signal, comparing means (42) for comparing with a predetermined table, and displaying means (43) for displaying the measurement obtained.

4. Method for measuring loop impedance, which can be carried out by the apparatus (10) according to any one of the preceding claims, wherein the method comprises at least the following steps: measurement of the Vgen input signal at the terminals A, B of the current generator (5) using the differential amplifier (1) and conditioning of the signal; transmission of the conditioned signal, sampling and saving of the data collected, and selection of a frequency in a range between 0 and 200 Hertz, the selected frequency being free of interference identified by calculating an estimate of the power spectrum of Vgen and selecting the component with the magnitude which is on average the lowest using the frequency selector (2); generation by the current generator (5) of the Igen current at the frequency identified; filtering of the Vgen signal by the digital filter (3), in such a way as to extract the component of Vgen at the frequency identified; and processing of the filtered Vgen signal and calculation of the loop impedance as the ratio of Vgen to Igen which are measured simultaneously at the terminals A, B of the current generator (5) by the processing means (4).

## Patentansprüche

1. Vorrichtung (10) zur Messung der Schleifenimpedanz, beinhaltend einen Differenzverstärker (1), der dazu ausgelegt ist, das Vgen-Eingangssignal aufzubereiten, und einen Stromgenerator (5), der von einem Mikrocontroller (6) gesteuert wird, so ausgelegt, dass er ein Igen-Stromsignal zwischen zwei Messanschlüssen A, B, fließen lässt, wobei der Mikrocontroller (6) einen Frequenzwähler (2) beinhaltet, der dazu ausgelegt ist, störungsfreie Frequenzen in einem Bereich zwischen 0 und 200 Hertz so zu identifizieren, dass ein Igen-Strom mit der identifizierten Frequenz erzeugt wird, einen Digitalfilter (3), der dazu ausgelegt ist, nur die Vgen-Komponente bei der identifizierten Frequenz zu extrahieren, und Verarbeitungsmittel (4) zur Verarbeitung des gefilterten Vgen-Signals, die dazu ausgelegt sind, die Impedanzmessung bereitzustellen, **gekennzeichnet dadurch, dass** der Frequenzwähler (2) dazu ausgelegt ist, störungsfreie Frequenzen in einem Bereich zwischen 0 und 200 Hertz zu identifizieren, indem er eine Schätzung des Leistungsspektrums von Vgen berechnet und dabei die Komponente mit der Amplitude wählt, die im Durchschnitt die niedrigste ist.

2. Vorrichtung (10) nach dem Patentanspruch 1, wobei der Frequenzwähler (2) einen Analog-Digital-Wandler (21), der dazu ausgelegt ist, Stichproben des Werts von Vgen zu sammeln, Speichermittel (22), um die gesammelten Stichproben zu speichern, und Analysemittel (23), die dazu ausgelegt sind, die Frequenzen, die am störungsfreiesten sind, zu identifizieren, beinhaltet.

3. Vorrichtung (10) nach dem Patentanspruch 1 oder 2, wobei die Verarbeitungsmittel (4) Berechnungsmittel (41) zur Berechnung des tatsächlichen Werts des gefilterten Vgen-Signals, Vergleichsmittel (42) zum Vergleich mit einer vorher festgelegten Tabelle, und Anzeigemittel (43) zur Anzeige der erhaltenen Messung beinhalten.

4. Verfahren zur Messung der Schleifenimpedanz, das durch die Vorrichtung (10) nach jedem der vorherigen Patentansprüche durchgeführt werden kann, wobei das Verfahren mindestens folgende Schritte beinhaltet: die Messung des Vgen-Eingangssignals an den Anschlüssen A, B des Stromgenerators (5) unter Verwendung des Differenzverstärkers (1) und Aufbereitung des Signals; Übertragung des aufbereiteten Signals, Stichprobenkontrolle und Speicherung der gesammelten Daten, und Auswahl einer Frequenz in einem Bereich zwischen 0 und 200 Hertz, wobei die ausgewählte Frequenz störungsfrei ist, identifiziert durch die Berechnung einer Schätzung des Leistungsspektrums von Vgen und durch Auswahl der Komponente mit der Amplitude, die im Durchschnitt die niedrigste ist, unter Verwendung des Frequenzwählers (2); Erzeugung des Igen-Stroms mit der identifizierten Frequenz durch den Stromgenerator (5); Filterung des Vgen-Signals durch den Digitalfilter (3), solcherart, dass die Vgen-Komponente bei der identifizierten Frequenz extrahiert wird; und Verarbeitung des gefilterten Vgen-Signals und Berechnung der Schleifenimpedanz als Verhältnis von Vgen zu Igen, die gleichzeitig an den Anschlüssen A, B des Stromgenerators (5) gemessen werden, durch die Verarbeitungsmittel (4).

## Revendications

1. Appareil (10) pour la mesure de l'impédance de boucle, comprenant un amplificateur différentiel (1) configuré pour conditionner un signal d'entrée Vgen, et un générateur de courant (5), contrôlé par un microcontrôleur (6), configuré pour faire circuler un signal de courant Igen entre deux bornes de mesure A, B, dans lequel le microcontrôleur (6) comprend un sélecteur de fréquence (2), configuré pour identifier des fréquences qui sont libres d'interférence dans une plage allant de 0 à 200 Hertz de manière à générer un courant Igen à la fréquence identifiée, un filtre numérique (3), configuré pour extraire uniquement la composante de Vgen à la fréquence identifiée, et des moyens de traitement (4) pour traiter le signal Vgen filtré, qui sont configurés pour fournir la mesure de l'impédance, **caractérisé en ce que** le sélecteur de fréquence (2) est configuré pour identifier des fréquences qui sont libres d'interférence dans une plage allant de 0 à 200 Hertz en calculant une estimation du spectre de puissance de Vgen et en sélectionnant la composante avec l'ampleur qui est en moyenne la plus petite.

2. Appareil (10) selon la revendication 1, dans lequel le sélecteur de fréquence (2) comprend un convertisseur analogique-numérique (21), configuré pour collecter des échantillons de la valeur de Vgen, des moyens de mémorisation (22) pour mémoriser les échantillons collectés, et des moyens d'analyse (23) configurés pour identifier les fréquences les plus libres d'interférence.

3. Appareil (10) selon la revendication 1 ou 2, dans lequel les moyens de traitement (4) comprennent des moyens de calcul (41) pour calculer la valeur efficace du signal Vgen filtré, des moyens de comparaison (42) pour comparer avec un tableau prédéterminé, et des moyens d'affichage (43) pour afficher la mesure obtenue.

4. Procédé pour la mesure de l'impédance de boucle, qui peut être exécuté par l'appareil (10) selon l'une quelconque des revendications précédentes, dans lequel le procédé comprend au moins les étapes suivantes : mesure du signal d'entrée Vgen aux bornes A, B du générateur de courant (5) à l'aide de l'amplificateur différentiel (1) et conditionnement du signal ; transmission du signal conditionné, échantillonnage et mémorisation des données collectées, et sélection d'une fréquence dans une plage allant de 0 à 200 Hertz, la fréquence sélectionnée libre d'interférence étant identifiée en calculant une estimation du spectre de puissance de Vgen et en sélectionnant la composante avec l'ampleur qui est en moyenne la plus petite à l'aide du sélecteur de fréquence (2) ; génération par le générateur de courant (5) du courant Igen à la fréquence identifiée ; filtrage du signal Vgen par le filtre numérique (3), de manière à extraire la composante de Vgen à la fréquence identifiée ; et traitement du signal Vgen filtré et calcul de l'impédance de boucle comme étant le rapport entre Vgen et Igen qui sont mesurées simultanément aux bornes A, B du générateur de courant (5) par les moyens de traitement (4).
